# EUROPEAN PATENT SPECIFICATION

(11) **EP 1 857 478 B1**
(45) Date of publication and mention of the grant of the patent: **02.09.2009**
(21) Application number: 06711602.0
(22) Date of filing: 12.01.2006
(51) Int. Cl.: C08F 236/20

(54) **CURABLE RESIN COMPOSITION FOR INK-JET PRINTING, CURED OBJECT OBTAINED THEREFROM, AND PRINTED WIRING BOARD OBTAINED WITH THE SAME**
HÄRTBARE HARZZUSAMMENSETZUNG ZUM TINTENSTRAHLDRUCKEN, DARAUS GEWONNENES GEHÄRTETES OBJEKT UND DARAUS GEWONNENE LEITERPLATTE
COMPOSITION DE RESINE DURCISSABLE CONÇUE POUR L'IMPRESSION PAR JET D'ENCRE, OBJET OBTENU PAR DURCISSEMENT DE CETTE COMPOSITION, ET CARTE DE CIRCUITS IMPRIMES PRODUITE AU MOYEN DE LADITE COMPOSITION

(30) Priority: 12.01.2005 JP 2005004766
(43) Date of publication of application: 21.11.2007
(73) Proprietor: TAIYO INK MFG. CO., LTD., Nerima-ku, Tokyo 176-8508 (JP)
(72) Inventor: USHIKI, Shigeru c/o TAIYO INK MFG. CO., LTD., Ranzanmachi, Hiki-gun, Saitama 355-0222 (JP); KUSAMA, Masatoshi c/o TAIYO INK MFG. CO., LTD., Ranzanmachi, Hiki-gun, Saitama 355-0222 (JP); MAKITA, Shohei c/o TAIYO INK MFG. CO. , LTD., Ranzanmachi, Hiki-gun, Saitama 355-0222 (JP)
(74) Representative: HOFFMANN EITLE
(86) International application number: PCT/JP2006/300279
(87) International publication number: WO 2006/075654

(56) References cited:
- JP-A- 08 277 265
- JP-A- 63 095 263
- JP-A- 2002 265 541
- JP-A- 2005 134 743

## Description

### Technical Field

The present invention relates to a curable resin composition for an ink jet printer useful for fabrication of printed wiring boards and excellent in heat resistance, a cured product of the composition, and a printed wiring board using the composition. More particularly, the invention relates to a curable resin composition for an ink jet printer usable for solder mask and marking ink to be used for fabrication of printed wiring boards, having a low viscosity, excellent in workability and storage stability as well as heat resistance, chemical resistance and electroless gold plating resistance, a cured product of the composition, and a printed wiring board using the composition.

### Background Art

Presently, as some of solder mask compositions for printed wiring boards for public use and printed wiring boards for industrial use, there has been used a liquid development type solder mask with which images are formed by development after ultraviolet radiation and then finishing curing (main curing) by heat and light radiation, in terms of high precision and high density. In consideration of environmental issues, an alkali development type liquid solder mask, for which an aqueous diluted alkaline solution is used as a developer, has been mainly used. As such an alkali development type solder mask composition for which an aqueous diluted alkaline solution is used, there are disclosed, for example, solder mask compositions (refer to Patent Document 1) consisting of a carboxyl group-containing photosensitive resin obtained by adding an acid anhydride to a reaction product of a novolak type epoxy resin and an unsaturated group-containing monocarboxylic acid, a photo polymerization initiator, a diluent, and an epoxy resin.

However, these solder mask compositions are two-component types since the reactivity of the carboxyl group-containing photosensitive resin and the epoxy resin is high, and accordingly, it is disadvantageous for them that these components have to be mixed before use and consumed within several days.

Further, these solder mask compositions require a large number of steps such as application, drying, exposure, development, and heat curing and for these steps, facilities such as an application apparatus, a dryer, an exposing apparatus, a development apparatus, and a heat curing furnace are necessary, leading to undesirable production cost increase.

To deal with these problems, formation of solder mask patterns by carrying out drawing with an ink jet printer and drying the drawn patterns has been proposed (refer to Patent Document 2). However, as compared with the viscosity of ink for screen printing, which is 2,000 to 15,000 mPa·s (25°C), the viscosity of ink for an ink jet printer is as low as 10 to 150 mPa·s (25°C), so that the viscosity of the ink is further lowered by heat during the drying and bleeding occurs. Consequently, no sufficient precision has been obtained yet, and practical application has not been realized yet.

Further, compositions containing, for lowering the viscosity, a low molecular weight compound such as an epoxy resin, e.g., trimethylolpropane triglycidyl ether and triallyl isocyanurate (TAIC) as a diluent have a problem of insufficient heat resistance and curability. On the other hand, compositions containing a bis-allyl-nadi-imide compound having a relatively low molecular weight and good heat resistance have to be cured at a high temperature around 250°C, and thus methods for curing using peroxides have been proposed (refer to Patent Document 3). However, in the case of employing a composition containing a peroxide for printed wiring boards, intense oxidation of a metal surface such as a copper foil occurs, resulting in deterioration of the performance.
Patent Document 1: Jpn. Pat. Appln. KOKAI Publication No. 61-243869 (Claims)
Patent Document 2: Jpn. Pat. Appln. KOKAI Publication No. 7-263845 (Claims)
Patent Document 3: Jpn. Pat. Appln. KOKAI Publication No. 7-18031 (Claims)

### Disclosure of Invention

### Problems to be Solved

The present invention has been made in view of the above problems, and it is an object of the invention to provide a curable resin composition for an ink jet printer usable for fabrication of printed wiring boards, having a low viscosity, excellent in workability and storage stability as well as heat resistance, chemical resistance, and electroless gold plating resistance, a cured product of the composition, and a printed wiring board using the composition.

### Means for Solving the Problems

To achieve the above-mentioned object, an aspect of the invention basically provides a curable resin composition for an ink jet printer containing:
(A) a bis-allyl-nadi-imide compound defined by the following general formula (1) : 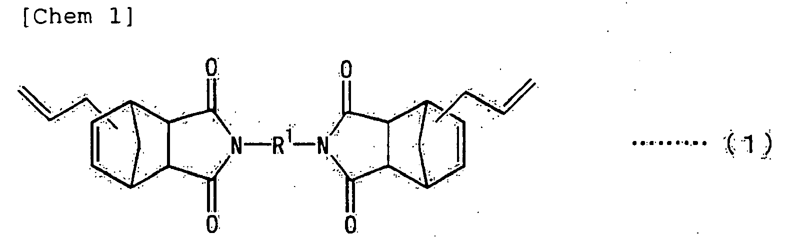 wherein R¹ represents an alkyl group having 2 to 18 carbon atoms, an aryl group, or an aralkyl group;
(B) a bismaleimide compound defined by the following general formula (2): 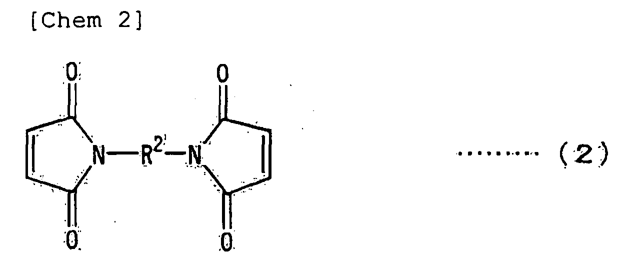 wherein R² represents an alkyl group having 2 to 32 carbon atoms, an aryl group, or an aralkyl group; and
(C) a diluent containing a polymerizable monomer (C-2) having an acryloyl group and/or a methacryloyl group; and having a viscosity of 150 mPa·s or lower at 25°C.

A preferable aspect of the invention provides a curable resin composition for an ink jet printer further containing an organic solvent (C-1) in the above-mentioned diluent (C).

In another aspect of the invention, the content ratio of the bis-allyl-nadi-imide compound
(A) is 30 to 96% by mass in the composition excluding the organic solvent. Further, the content ratio of the bismaleimide compound (B) is 4 to 45 parts by mass with respect to 100 parts by mass of the bis-allyl-nadi-imide compound (A). The content ratio of the diluent (C) is 25 to 1900 parts by mass with respect to 100 parts by mass of the bis-allyl-nadi-imide compound (A), with a proviso that.in the case where the diluent (C) is a polymerizable monomer (C-2) alone, the content ratio of the diluent (C) is 25 to 200 parts by mass.

Further, another aspect of the invention provides a cured product obtained by drawing desirable patterns of the above-mentioned curable resin composition for an ink jet printer by an ink jet printer and thermally curing the composition, and a printed wiring board having a solder mask of the cured product.

### Advantages of the Invention

Since the curable resin composition for an ink jet printer of the invention has a low viscosity, it is possible to apply the composition by an ink jet printer. Further, the cured product obtained by thermally curing the curable resin composition for an ink jet printer of the invention is excellent in heat resistance, and accordingly it can be used as a solder mask or marking ink for printed wiring boards. In this manner, it is made possible to improve the productivity and lower the cost of printed wiring boards by forming a solder mask by an ink jet printer.

Further, it is also made possible to simplify the process, improve the productivity, and lower the cost such as maintenance cost of facilities by forming the solder mask consisting of the curable resin composition of the present invention by an ink jet printer.

### Best Mode for Carrying Out the Invention

The inventors of the invention have made various investigations for solving the above-mentioned problems and have found that it is possible for a composition containing compounds (A), (B), and (C) to have a viscosity of 150 mPa·s or lower at 25°C, which is suitable for application by an ink jet printer, while maintaining the properties necessary for solder mask and marking ink to be used for printed wiring boards. Compound (A): a bis-allyl-nadi-imide compound defined by the following general formula (1): 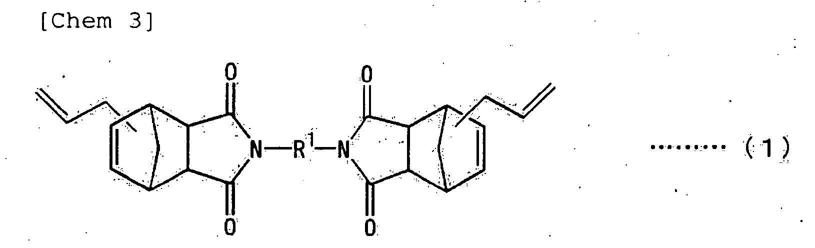 wherein R¹ represents an alkyl group having 2 to 18 carbon atoms, an aryl group, or an aralkyl group; Compound (B): a bismaleimide compound defined by the following general formula (2): 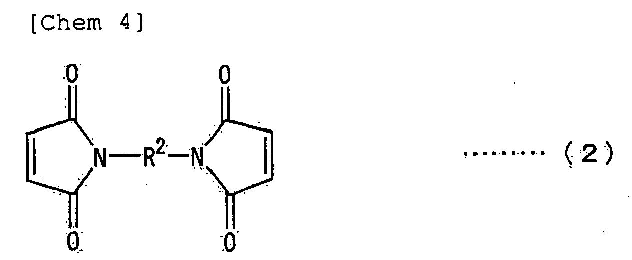 wherein R² represents an alkyl group having 2 to 32 carbon atoms, an aryl group, or an aralkyl group; and Compound (C): a diluent as defined above.

These findings have now led to completion of the invention.

That is, although a bis-allyl-nadi-imide compound (A) defined by the formula (1) of the invention is not thermally cured by itself unless heated to around 250°C, the curing temperature thereof can be lowered to a temperature common in printed wiring board production, that is, from 100 to 200°C, preferably 140 to 180°C, by using a bismaleimide compound (B) defined by the formula (2) of the invention, which is a characteristic of the invention. Further, combination use of the bis-allyl-nadi-imide compound (A) and the bismaleimide compound (B) makes it possible to lower the crystallinity of the bismaleimide compound (B), and further addition of the diluent (C) makes it possible to provide a liquid composition with a low viscosity and excellent in storage stability.

Hereinafter, the respective components of the curable resin composition for an ink jet printer will be described in detail.

The bis-allyl-nadi-imide compound (A) to be used in the invention is a compound defined by the following formula (1) : 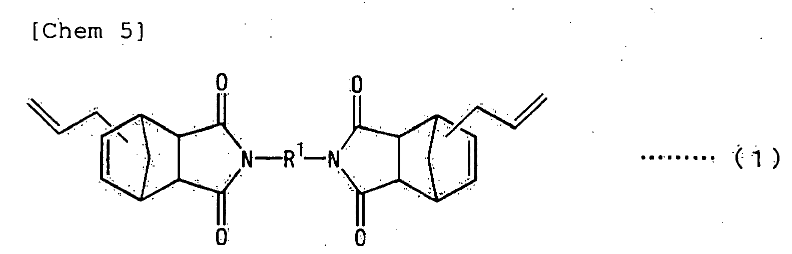 wherein R¹ represents an alkyl group having 2 to 18 carbon atoms, an aryl group, or an aralkyl group.

Particularly preferable compounds are those in which R¹ is defined by the following formulas (3), (4), and (5) : 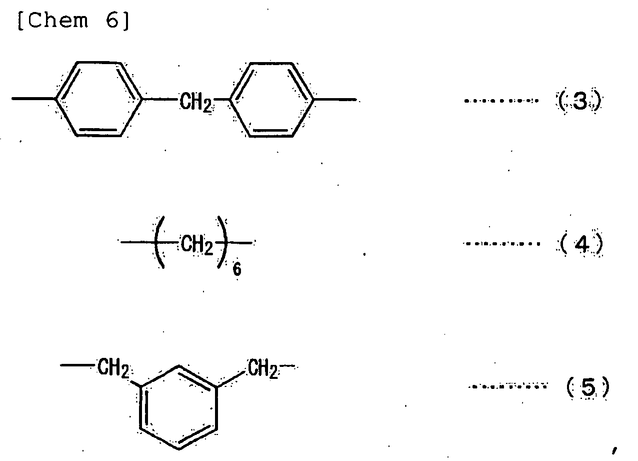 and specifically BANI-M, BANI-H, and BANI-X (all grade names of products) manufactured by Maruzen Petrochemical Co., Ltd. are available.

These bis-allyl-nadi-imide compounds (A) may be used alone or two or more of them may be mixed for use and the content ratio is preferably in the range of 30 to 96% by mass in the composition excluding the organic solvent to be used for the diluent (C), which will be described later.

If necessary, a mono-allyl-nadi-imide effective for dilution, for example, ANI-HP (grade name of a product) manufactured by Maruzen Petrochemical Co., Ltd. may be added.

The above-mentioned bismaleimide compound (B) to be used in the invention may be a compound defined by the following formula (2): 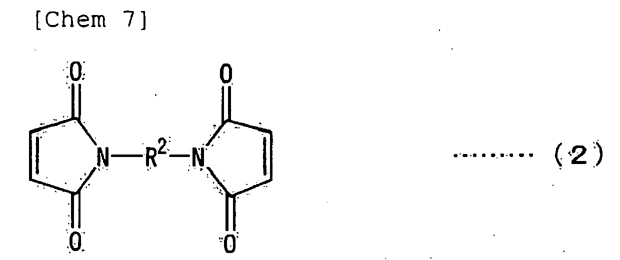 wherein R² represents an alkyl group having 2 to 32 carbon atoms, an aryl group, or an aralkyl group.

Particularly preferable compounds are those in which R² is defined by the following formulas (6), (7), (8), and (9): 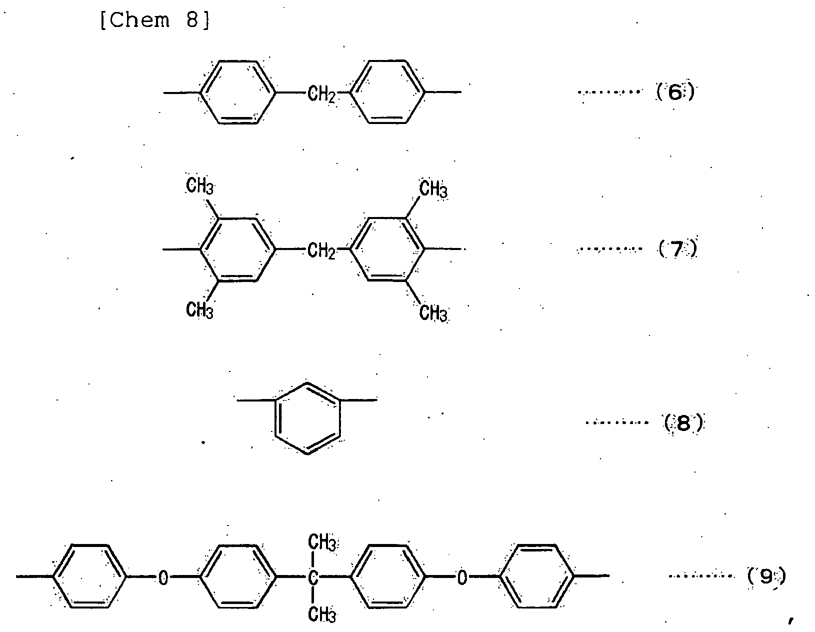 and specifically BMI, BMI-70, and BMI-80 (all grade names of products) manufactured by K. I. Chemical Industry Co., Ltd. and BMI-1000, BMI-3000, BMI-4000, and BMI-5000 (all grade names of products) manufactured by Daiwa Kasei Industry Co., Ltd. are available.

These bismaleimide compounds (B) may be used alone or two or more of them may be mixed for use and the content ratio is in the range of 4 to 45 parts by mass, preferably 15 to 35 parts by mass with respect to 100 parts by mass of the above-mentioned bis-allyl-nadi-imide compound (A). If the content ratio of the bismaleimide compound (B) is less than 4 parts by mass with respect to 100 parts by mass of the bis-allyl-nadi-imide compound (A), the curability is lowered and it is not undesirable. On the other hand, if it exceeds 45 parts by mass with respect to 100 parts by mass of the bis-allyl-nadi-imide compound (A), the heat resistance and curability are lowered and the crystallinity becomes high to cause clogging of an ink jet nozzle and it is not undesirable.

If necessary, a monomaleimide compound effective for dilution, for example, phenylmaleimide, cyclohexylmaleimide, polyfunctional maleimide compounds derived from aniline resin effective for improving the curability, for example, BMI-2000 (grade name of a product) may be added.

As the diluent (C) in the invention, there may be used an organic solvent (C-1). The diluent contains a polymerizable monomer (C-2) having an acryloyl group and/or a methacryloyl group.

Examples of the above-mentioned organic solvent (C-1) may be conventionally known organic solvents, e.g., ketones such as methyl ethyl ketone and cyclohexanone; aromatic hydrocarbons such as toluene, xylene, and tetramethylbenzene; glycol ethers such as cellosolve, methyl cellosolve, butyl cellosolve, carbitol, methyl carbitol, butyl carbitol, propylene glycol methyl ether, dipropylene glycol monomethyl ether, dipropylene glycol diethyl ether, tripropylene glycol monomethyl ether; esters such as ethyl acetate, butyl acetate, butyl lactate, cellosolve acetate, butyl cellosolve acetate, carbitol acetate, butyl carbitol acetate, propylene glycol monomethyl ether acetate, dipropylene glycol monomethyl ether acetate, and propylene carbonate; aliphatic hydrocarbons such as octane and decane; and petroleum type solvents such as petroleum ethers, petroleum naphtha, and solvent naphtha. These organic solvents may be used alone or two or more of them may be used in combination.

Examples of the above-mentioned polymerizable monomer (C-2) having one or more acryloyl and/or methacryloyl groups in a molecule include 2-ethylhexyl (meth)acrylate, lauryl (meth)acrylate, isostearyl (meth)acrylate, 2-hydroxyethyl (meth)acrylate, 2-hdyroxypropyl (meth)acrylate, 2-methoxyethyl (meth)acrylate, isobutyl (meth)acrylate, tert-butyl (meth)acrylate, butoxyethyl (meth)acrylate, methyl triglycol (meth)acrylate, cyclohexyl acrylate, 2-ethylhexyl carbitol acrylate, 4-hydroxybutyl (meth)acrylate, isoboronyl (meth)acrylate, methoxydiethylene glycol (meth)acrylate, ethoxydiethylene glycol (meth)acrylate, 3-methoxybutyl (meth)acrylate, methoxypropylene glycol (meth)acrylate, benzyl (meth)acrylate, phenoxyethyl (meth)acrylate, 1,3-butylene glycol di(meth)acrylate, 1,5-pentanediol di(meth)acrylate, neopentyl glycol di(meth)acrylate, tetrahydrofurfuryl (meth)acrylate, 1,4-butanediol di(meth)acrylate, 1,6-hexanediol di(meth)acrylate, diethylene glycol di(meth)acrylate, triethylene glycol di(meth)acrylate, 4-(meth)acryloyloxymethyl-2-methyl-2-ethyl-1,3-dioxolane, 4-(meth)acryloyloxymethyl-2-isobutyl-2-ethyl-1,3-dioxolane, 4-(meth)acryloyloxymethyl-2-cyclohexyl-1,3-dioxolane, trimethylolpropane tri(meth)acrylate, trimethylolpropane tri(meth)acrylate, pentaerythritol tri(meth)acrylate, pentaerythritol tetra(meth)acrylate, dipentaerythritol hexa(meth)acrylate, and dipentaerythritol penta(meth)acrylate.

Among them, compounds having 1 to 4 acryloyl groups and/or methacryloyl groups in a molecule are preferable and compounds giving a viscosity of 300 mPa·s or lower at 25°C are more preferable.

These polymerizable monomers (C-2) may be used alone or two or more of them may be used in form of a mixture.

In this specification, (meth)acrylate means acrylate, methacrylate, and their mixture and similar expressions are the same as described.

The content ratio of the diluent (C) is preferably 25 to 1900 parts by mass, more preferably 40 to 400 parts by mass with respect to 100 parts by mass of the above-mentioned bis-allyl-nadi-imide compound (A). The content ratio of the polymerizable monomer (C-2) in the entire diluent (C) is preferably 25 to 200 parts by mass with respect to 100 parts by mass of the above-mentioned bis-allyl-nadi-imide compound (A). If the content ratio of the diluent (C) is less than 25 parts by mass with respect to 100 parts by mass of the above-mentioned bis-allyl-nadi-imide compound (A), dissolution of the bis-allyl-nadi-imide compound (A) fails or the viscosity is increased to make application impossible and therefore, it is not preferable. Further, in the case where the content ratio of the polymerizable monomer (C-2) in the total diluent (C) exceeds 200 parts by mass with respect to 100 parts by mass of the bis-allyl-nadi-imide compound (A), cracking of the coating film tends to be caused easily at the time of curing and therefore it is not preferable.

The curable resin composition for an ink jet printer of the invention may contain a radical polymerization initiator (D) which generates radicals by heat or active energy ray radiation in order to improve the curability. Examples of such a radical polymerization initiator (D) may be conventionally known polymerization initiators excluding peroxides oxidizing the metal surface such as a copper foil, and practical examples thereof are benzoin and benzoin alkyl ethers such as benzoin, benzoin methyl ether, benzoin ethyl ether, and benzoin isopropyl ether; acetophenones such as acetophenone, 2,2-dimethoxy-2-phenylacetophenone, 2,2-diethoxy-2-phenylacetophenone, and 1,1-dichloroacetophenone; aminoacetophenones such as 2-methyl-1-[4-(methylthio)phenyl]-2-monopholino-propan-1-one, 2-benzyl-2-dimethylamino-1-(4-morpholinophenyl)-butan-1-one, and N,N-dimethylaminoacetophenone; anthraquinones such as 2-methylanthraquinone, 2-ethylanthraquinone, 2-tert-butylanthraquinone, and 1-chloroanthraquinone; thioxanthones such as 2,4-dimethylthioxanthone, 2,4-diethylthioxanthone, 2-chlorothioxanthone, and 2,4-diisopropylthioxanthone; ketals such as acetophenone dimethyl ketal and benzyl dimethyl ketal; benzophenones and xanthones such as benzophenone and 4,4'-bisdiethylaminobenzophenone; halomethyloxadiazole type compounds such as 2,4,6-trimethylbenzoyldiphenylphosphine oxide, 2-trichloromethyl-5-styryl-1,3,4-oxadiazole, 2-trichloromethyl-5-(p-cyanostyryl)-1,3,4-oxadiazole; and halomethyl-s-triazine type compounds such as 2,4-bis(trichloromethyl)-6-(p-methoxy-phenylvinyl)-1,3,5-triazine, 2,4-bis(trichloromethyl)-6-p-methoxystyryl-s-triazine, and 2,4-bis(trichloromethyl)-6-(1-p-dimethylaminophenyl-1,3-butadienyl)-s-triazine.

Further, polymerization initiator aids, for example, tertiary amines such as N,N-dimethylaminobenzoic acid ethyl ester, N,N-dimethylaminobenzoic acid isoamyl ester, and pentyl 4-dimethylaminobenzoate, triethylamine, and triethanolamine may be added.

These radical polymerization initiators (D) may be added alone or two or more of them may be used in form of a mixture and the content ratio thereof is 10% by mass or less, preferably 0.5 to 5% by mass in the composition excluding the organic solvent (C-1) as the diluent (C). If the content ratio of the radical polymerization initiator (D) exceeds 10% by mass, the coating film properties are deteriorated and therefore, it is not preferable.

Further, the curable resin composition for an ink jet printer of the invention may contain an inorganic filler in form of ultra fine powder such as nano-silica and an inorganic pigment such as titanium oxide.

The content ratio thereof is preferably 30 parts by mass or lower with respect to 100 parts by mass of non-volatile matter in the solder mask composition. If the content ratio exceeds 30 parts by mass, the viscosity of the solder mask composition is increased and the ink jet coatability is decreased and the curability is deteriorated, and therefore it is not preferable.

Further, the curable resin composition for an ink jet printer may further contain various kinds of additives, for example, an antioxidant, e.g., guanamines such as dicyanodiamide, o-tolylbiguanide, guanamine, acetoguanamine, and benzoguanamine, and melamine; an organic pigment of anthraquinone type, perylene type, disazo type, isoindoline type, and phthalocyanine type; a defoaming agent; a pressure adhesiveness-providing agent; a leveling agent; and a pigment dispersant.

The content ratio of these additives may be 5 parts by mass or less with respect to 100 parts by mass of the non-volatile matter of the solder mask composition. If the addition amount of the additives exceeds 5 parts by mass, the viscosity of the solder mask composition is increased and the ink jet coatability is lowered and the coating film properties are deteriorated and therefore, it is not preferable.

The curable resin composition for an ink jet printer of the invention obtained by mixing the above-mentioned components is adjusted by mixing and dispersing the components by a stirrer or a dispersing apparatus such as a roll mill, a sand mill, a ball mill, a beads mill, or an attriter until the composition becomes uniform.

The curable resin composition for an ink jet printer of the invention obtained in the above-mentioned manner is adjusted by the diluent (C) to have a viscosity of 150 mPa·s or lower, preferably from 5 to 110 mPa·s, at 25°C in order to make application by an ink jet printer possible.

The curable resin composition for an ink jet printer of the invention obtained in the above-mentioned manner is used for forming solder mask patterns of a cured product with excellent heat resistance and so on by drawing desired patterns of the composition by an ink jet printer on the surface of a printed wiring board, in which a circuit is formed, and heating the patterns of the composition at 100 to 200°C, preferably 140 to 180°C, for 10 to 60 minutes for heat curing. In the case of a composition containing the polymerizable monomer (C-2) as the diluent (C) and the radical polymerization initiator (D) for generating radical by active energy ray radiation, it is made possible to form patterns with little bleeding and so on by drawing desired patterns of the composition by an ink jet printer on the surface of a printed wiring board, in which a circuit is formed, and carrying out photo-curing by radiating an active energy ray such as ultraviolet rays to the patterns of the composition. After that, heat curing is further carried out at 100 to 200°C, preferably 140 to 180°C, for 10 to 60 minutes to form solder mask patterns of a cured product with excellent heat resistance.

As the above-mentioned ink jet printer, there is preferably employed an on-demand piezoelectric ink jet printer, and application of the composition can be carried out at room temperature, or by heating the nozzle to about 60°C or lower.

Further, as a light source for the above-mentioned active energy ray radiation, there is employed a low pressure mercury lamp, a medium pressure mercury lamp, a high pressure mercury lamp, an ultrahigh pressure mercury lamp, a xenon lamp, a metal halide lamp and so on. A laser beam is also usable as the active energy ray.

As described above, unlike an alkali-development type solder mask, no complicated process is needed, so that a highly reliable printed wiring board which is free from ionic substance adhesion can be provided at a low cost.

### [Examples]

Hereinafter, the invention will be better understood from the following practical examples of the invention, but it is not intended that the invention is limited to the illustrated examples. "Part" in this specification means parts by mass unless otherwise specified.

The respective mixing components shown in the following Table 1 were mixed and stirred and filtered with a 1 µm filter to obtain curable resin compositions for an ink jet printer.

**Table 1**

| Component | | *14 Exam.1 | Exam.2 | Exam.3 | Exam.4 | Exam.5 | Exam.6 | Exam.7 | Exam.8 | Exam.9 | Exam.10 | Exam.11 | Comp.1 |
|---|---|---|---|---|---|---|---|---|---|---|---|---|---|
| A | Bis-allyl-nadi-imide 1^{*1} | 8 | 8 | 8 | 8 | 8 | 8 | 8 | 8 | - | - | 8 | 10 |
| | Bis-allyl-nadi-imide 2^{*2} | - | - | - | - | - | - | - | - | 8 | - | - | - |
| | Bis-allyl-nadi-imide 3^{*3} | - | - | - | - | - | - | - | - | - | 8 | - | - |
| B | Bismaleimide 1^{*4} | 2 | 2 | 2 | 2 | - | - | - | - | 2 | 2 | 2 | - |
| | Bismaleimide 2^{*5} | - | - | - | - | 2 | - | - | - | - | - | - | - |
| | Bismaleimide 3^{*6} | - | - | - | - | - | 2 | - | - | - | - | - | - |
| | Bismaleimide 4^{*7} | - | - | - | - | - | - | 2 | - | - | - | - | - |
| | Bismaleimide 5^{*8} | - | - | - | - | - | - | - | 2 | - | - | - | - |
| C | Diluent 1^{*9} | 10 | - | - | - | - | - | - | - | - | - | 2 | - |
| | Diluent 2^{*10} | - | 10 | - | 10 | 10 | 10 | 10 | 10 | 10 | 10 | 8 | 10 |
| | Diluent 3^{*11} | - | - | 10 | - | - | - | - | - | - | - | - | - |
| . | Initiator^{*12} | 0.2 | 0.2 | 0.2 | 0.2 | 0.2 | 0.2 | 0.2 | 0.2 | 0.2 | 0.2 | 0.2 | 0.2 |
| | Additive^{*13} | - | - | - | 0.01 | - | - | - | - | - | - | - | - |
| Total | | 20.2 | 20.2 | 20.2 | 20.21 | 20.2 | 20.2 | 20.2 | 20.2 | 20.2 | 20.2 | 20.2 | 20.2 |
| *1: A bis-allyl-nadi-imide compound represented by formula (1), wherein R1 is defined by formula (5). (BANI-X; Maruzen Petrochemical Co., Ltd.) | | | | | | | | | | | | | |
| *2: A bis-allyl-nadi-imide compound represented by formula (1), wherein R1 is defined by formula (4). (BANI-H; Maruzen Petrochemical Co., Ltd.) | | | | | | | | | | | | | |
| *3: A bis-allyl-nadi-imide compound represented by (1), wherein R1 is defined by formula (3). (BANI-M; Maruzen Petrochemical Co., Ltd.) | | | | | | | | | | | | | |
| *4: A bismaleimide compound represented by formula (2), wherein R2 is defined by formula (9). (BMI-80; K. I. Chemical Industry Co., Ltd.) | | | | | | | | | | | | | |
| *5 A bismaleimide compound represented by formula (2), wherein R2 is defined by formula (7). (BMI-70; K. I. Chemical Industry Co., Ltd.) | | | | | | | | | | | | | |
| *6: A bismaleimide compound represented by formula (2), wherein R2 is defined by formula (6). (BMI; K. I. Chemical Industry Co., Ltd.) | | | | | | | | | | | | | |
| *7: A bismaleimide compound represented by formula (2), wherein R2 is defined by formula (8). (BMI-3000; Daiwa Kasei Industry Co., Ltd.) | | | | | | | | | | | | | |
| *8: MIE-200 manufactured by Dainippon ink and chemicals, incorporated. | | | | | | | | | | | | | |
| *9: Propylene glycol monomethyl ether acetate. | | | | | | | | | | | | | |
| *10: Methoxydiethylene glycol methacrylate (M-20G; SHIN-NAKAMURA CHEMICAL CO., LTD) | | | | | | | | | | | | | |
| *11: 4-hydroxybutyl acrylate | | | | | | | | | | | | | |
| *12: 2-methyl-1-[4-(methylthio)phenyl]-2-monopholino-propan-1-one | | | | | | | | | | | | | |
| *13: Phthalocyanine green | | | | | | | | | | | | | |
| *14: Reference Example | | | | | | | | | | | | | |

After each of the respective curable resin compositions for an ink jet printer obtained as described was subjected to viscosity measurement, the composition was applied using an on-demand type piezoelectric ink jet printer to form solder mask patterns on a printed wiring board (FR-4) in which a circuit was formed. In Example 1, after the application, heat curing was carried out at 160°C for 30 minutes in a hot air circulation type drying furnace. In the case of examples 2 to 11, after application, exposure to 2000 mJ/cm² intensity was carried out in a UV conveyer furnace and then heat curing was carried out at 160°C for 30 minutes in a hot air circulation type drying furnace.

The viscosity of each obtained composition and results of property evaluations of a cured coating film of each composition are shown in Table 2.

**Table 2**

| | *Exam.1 | Exam.2 | Exam.3 | Exam.4 | Exam.5 | Exam.6 | Exam.7 | Exam.8 | Exam.9 | Exam.10 | Exam.11 | Comp.1 |
|---|---|---|---|---|---|---|---|---|---|---|---|---|
| Viscosity(mPa·s) | 18 | 44 | 110 | 19 | 19 | 19 | 19 | 20 | 19 | 20 | 25 | 64 |
| Coating film hardness | ○ | ○ | ○ | ○ | ○ | ○ | ○ | ○ | ○ | ○ | ○ | × |
| Solvent resistance | ○ | ○ | ○ | ○ | ○ | ○ | ○ | ○ | ○ | ○ | ○ | × |
| Chemical resistance | ○ | ○ | ○ | ○ | ○ | ○ | ○ | ○ | ○ | ○ | ○ | △ |
| Soldering heat resistance | ○ | ○ | ○ | ○ | ○ | ○ | ○ | ○ | ○ | ○ | ○ | × |
| Electroless gold plating resistance | ○ | ○ | ○ | ○ | ○ | ○ | ○ | ○ | ○ | ○ | ○ | △ |
| Curability | ○ | ○ | ○ | ○ | ○ | ○ | ○ | ○ | ○ | ○ | ○ | × |
| Storage stability | ○ | ○ | ○ | ○ | ○ | ○ | ○ | ○ | ○ | ○ | ○ | ○ |

| | | | | | | | | | | | | |
|---|---|---|---|---|---|---|---|---|---|---|---|---|
| *Reference Example | | | | | | | | | | | | |

The evaluation methods for the property test in Table 2 were as described below.
(1) Viscosity
   The viscosity at 25°C of each of the curable resin compositions for an ink jet printer obtained in the above-mentioned manner was calculated from the specific gravity and dynamic viscosity according to the following.
   The specific gravity was measured by a specific gravity meter and the dynamic viscosity was measured by a Cannon Fenske viscometer.
   Viscosity (mPa·s) = dynamic viscosity (mm²/s) × specific gravity
(2) Coating film hardness
   The pencil hardness of each cured coating film on the copper foil was evaluated according to JIS K-5600-5-4 testing method.
   ○: those which showed 6 H or higher.
   ×: those which showed 5 H or lower.
(3) Solvent resistance
   The coating film state was evaluated after each cured coating film was immersed in propylene glycol monomethyl ether acetate for 30 minutes.
   ○: those which showed no alteration at all.
   Δ: those which showed slight alteration.
   ×: those which were swollen and parted.
(4) Chemical resistance
   The coating film state was evaluated after each cured coating film was immersed in 10 vol% hydrochloric acid for 10 minutes.
   ○: those which showed no alteration at all.
   Δ: those which showed slight alteration.
   ×: those which were swollen and parted.
(5) Soldering heat resistance
   The coating film state was evaluated after each cured coating film was immersed in a solder bath at 260°C for 5 seconds and successively subjected to a peeling test by cellophane tape.
   ○: those which showed no alteration at all.
   Δ: those which showed slight discoloration.
   ×: those which were peeled.
(6) Electroless gold plating resistance
   After plating of 0.5 µm nickel and 0.03 µm gold was carried out in a commercialized electroless nickel plating bath and an electroless gold plating bath, occurrence of peeling of each cured coating film was evaluated by tape peeling and occurrence of bleeding of the plating was evaluated.
   ○: those which showed no peeling at all.
   Δ: those which showed slight peeling.
   ×: those which were peeled.
(7) Curability
   Each cured coating film was scratched with a waste immersed in acetone and the surface state was evaluated.
   ○: no alteration at all.
   ×: the surface was dissolved or softened and scratched.
(8) Storage stability

After each curable resin composition for an ink jet printer obtained in the above-mentioned manner was stored at a normal temperature for one month, the viscosity was measured and the storage stability was evaluated from the results based on the following standard.
○: those which showed viscosity increase at a max of 1.5 times after 1 month storage at a normal temperature.
×: those which showed viscosity increase not lower than 1.5 times after 1 month storage at a normal temperature.

As is clear from the results in Table 2, the compositions of Examples 1 to 11 were found curable in conditions (e.g., at 160°C for 30 minutes) of producing printed wiring boards, having a low viscosity, and excellent in storage stability and accordingly the compositions were found usable as curable resin compositions for an ink jet printer. On the other hand, Comparative Example 1 in which no bismaleimide compound was added could not be sufficiently cured at 160°C for 30 minutes and accordingly was found inferior in the coating film hardness, solvent resistance, and soldering heat resistance.

## Claims

1. A curable resin composition for an ink jet printer containing:
(A) a bis-allyl-nadi-imide compound defined by the following general formula (1): 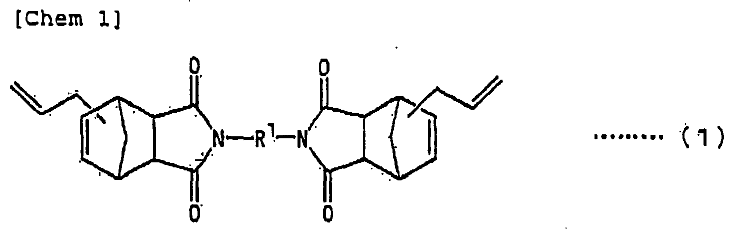 **characterized in that** R¹ represents an alkyl group having 2 to 18 carbon atoms, an aryl group, or an aralkyl group;
(B) a bismaleimide compound defined by the following general formula (2): 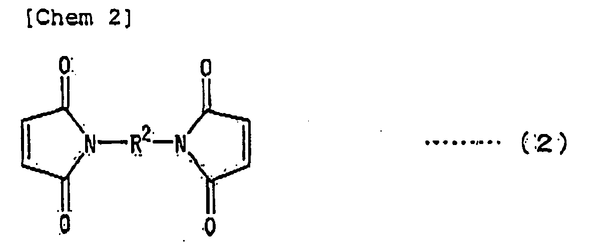 wherein R² represents an alkyl group having 2 to 32 carbon atoms, an aryl group, or an aralkyl group; and
(C) a diluent containing a polymerizable monomer (C-2) having an acryloyl group and/or a methacryloyl group; and having a viscosity of 150 mPa·s or lower at 25°C

2. The curable resin composition for an ink jet printer according to claim 1, **characterized in that** the diluent (C) further contains organic solvent (C-1).

3. The curable resin composition for an ink jet printer according to claim 1 or claim 2, **characterized in that** the content ratio of the bis-allyl-nadi-imide compound (A) is 30 to 96% by mass in the composition excluding the organic solvent.

4. The curable resin composition for an ink jet printer according to any one of claims 1 to 3, **characterized in that** the content ratio of the bismaleimide compound (B) is 4 to 45 parts by mass with respect to 100 parts by mass of the bis-allyl-nadi-imide compound (A).

5. The curable resin composition for an ink jet printer, according to claim 1, wherein the content ratio of the diluent (C) is 25 to 1900 parts by mass with respect to 100 parts by mass of the bis-allyl-nadi-imide compound (A), with a proviso that in the case where the diluent (C) is a polymerizable monomer (C-2) alone, the content ratio of the diluent (C) is 25 to 200 parts by mass.

6. A cured product obtained by applying the curable resin composition for an ink jet printer according to any one of claims 1 to 5 by an ink jet printer and thermally curing the composition.

7. A cured product obtained by applying the curable resin composition for an ink jet printer according to claim 1 by an ink jet printer, photo-curing the composition by radiating ultraviolet rays, and then thermally curing the composition.

8. A printed wiring board having a solder mask pattern obtained by applying the curable resin composition for an ink jet printer according to any one of claims 1 to 5 by an ink jet printer and thermally curing the composition.

9. A printed wiring board having a solder mask pattern obtained by applying the curable resin composition for an ink jet printer according to claim 1 by an ink jet printer, photo-curing the composition by radiating ultraviolet rays, and then thermally curing the composition.

## Patentansprüche

1. Härtbare Harzzusammensetzung für einen Tintenstrahldrucker, umfassend:
(A) eine Bisallylnadiimidverbindung, definiert durch die folgende allgemeine Formel (1): 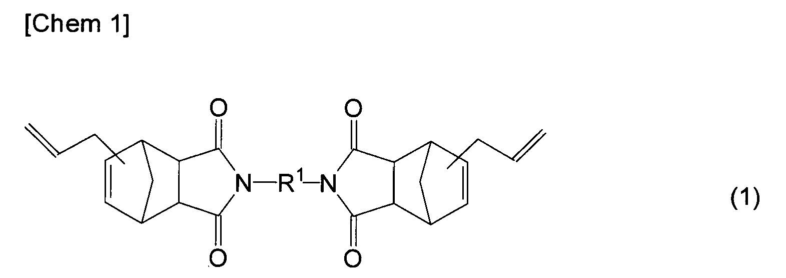 **dadurch gekennzeichnet, dass** R¹ eine Alkylgruppe mit 2 bis 18 Kohlenstoffatomen, Arylgruppe oder Aralkylgruppe ist;
(B) Bismaleimidverbindung, definiert durch die folgende allgemeine Formel (2): 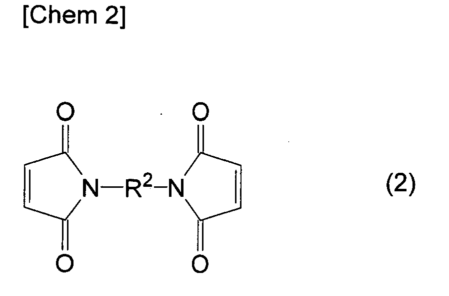 worin R² eine Alkylgruppe mit 2 bis 32 Kohlenstoffatomen, Arylgruppe oder Aralkylgruppe ist; und
(C) ein Verdünnungsmittel, umfassend ein polymerisierbares Monomer (C-2) mit einer Acryloylgruppe und/oder Methacryloylgruppe, und mit einer Viskosität von 150 mPa·s oder weniger bei 25°C.

2. Härtbare Harzzusammensetzung für einen Tintenstrahldrucker nach Anspruch 1, **dadurch gekennzeichnet, dass** das Verdünnungsmittel (C) weiterhin ein organisches Lösungsmittel (C-1) umfasst.

3. Härtbare Harzzusammensetzung für einen Tintenstrahldrucker nach Anspruch 1 oder Anspruch 2, **dadurch gekennzeichnet, dass** der Gehalt der Bisallylnadiimidverbindung (A) 30 bis 96 Massen-% in der Zusammensetzung ohne dem organischen Lösungsmittel ist.

4. Härtbare Harzzusammensetzung für einen Tintenstrahldrucker nach einem der Ansprüche 1 bis 3, **dadurch gekennzeichnet, dass** der Gehalt der Bismaleimidverbindung (B) 4 bis 45 Massenteile in Bezug auf 100 Massenteile der Bisallylnadiimidverbindung (A) ist.

5. Härtbare Harzzusammensetzung für einen Tintenstrahldrucker nach Anspruch 1, worin der Gehalt des Verdünnungsmittels (C) 25 bis 1900 Massenteile in Bezug auf 100 Massenteile der Bisallylnadiimidverbindung
(A) ist, mit dem Vorbehalt, dass in dem Fall, wenn das Verdünnungsmittel (C) ein polymerisierbares Monomer (C-2) alleine ist, der Gehalt des Verdünnungsmittels (C) 25 bis 200 Massenteile ist.

6. Gehärtetes Produkt, erhalten durch Auftragen der härtbaren Harzzusammensetzung für einen Tintenstrahldrucker nach einem der Ansprüche 1 bis 5 durch einen Tintenstrahldrucker und thermisches Härten der Zusammensetzung.

7. Gehärtetes Produkt, erhältlich durch Auftragen der härtbaren Harzzusammensetzung für einen Tintenstrahldrucker nach Anspruch 1 durch einen Tintenstrahldrucker, Fotohärten der Zusammensetzung durch Bestrahlen mit Ultraviolettstrahlen und anschließendes thermisches Härten der Zusammensetzung.

8. Gedruckte Leiterplatte mit einem Lötmaskiermuster, erhalten durch Auftragen der härtbaren Harzzusammensetzung für einen Tintenstrahldrucker nach einem der Ansprüche 1 bis 5 durch einen Tintenstrahldrucker und thermisches Härten der Zusammensetzung.

9. Gedruckte Leiterplatte mit einem Lötmaskiermuster, erhalten durch Auftragen der härtbaren Harzzusammensetzung für einen Tintenstrahldrucker nach Anspruch 1 durch einen Tintenstrahldrucker, Fotohärten der Zusammensetzung durch Strahlen mit Ultraviolettstrahlen und anschließendes thermisches Härten der Zusammensetzung.

## Revendications

1. Composition de résine durcissable pour une imprimante à jet d'encre, contenant :
(A) un composé de bis-allyl-nadi-imide défini par la formule (1) générale suivante : 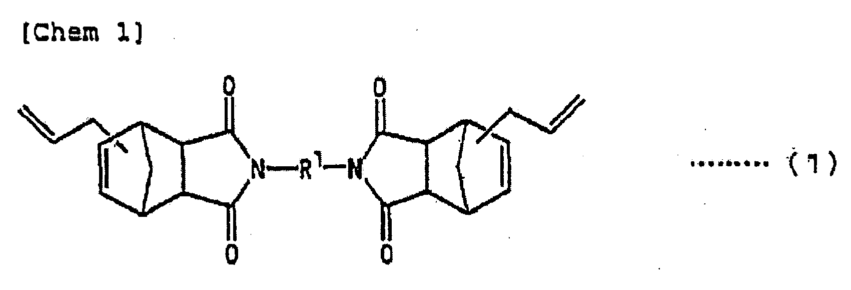 **caractérisée en ce que** R¹ représente un groupe alkyle contenant 2 à 18 atomes de carbone, un groupe aryle ou un groupe aralkyle ;
(B) un composé de bismaléimide défini par la formule (2) générale suivante : 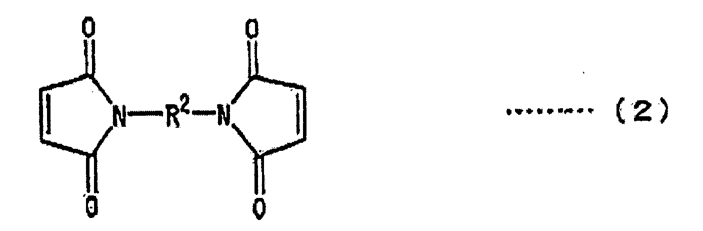 dans laquelle R² représente un groupe alkyle contenant 2 à 32 atomes de carbone, un groupe aryle ou un groupe aralkyle ; et
(C) un diluant contenant un monomère polymérisable (C-2) possédant un groupe acryloyle et/ou un groupe méthacryloyle ; et possédant une viscosité inférieure ou égale à 150 mPa.s à 25 °C.

2. Composition de résine durcissable pour une imprimante à jet d'encre selon la revendication 1, **caractérisée en ce que** le diluant (C) contient en outre un solvant organique (C-1).

3. Composition de résine durcissable pour une imprimante à jet d'encre selon la revendication 1 ou la revendication 2, **caractérisée en ce que** la teneur du composé (A) de bis-allyl-nadi-imide est dé 30 à 96 % en poids dans la composition sans le solvant organique.

4. Composition de résine durcissable pour une imprimante à jet d'encre selon l'une quelconque des revendications 1 à 3**, caractérisée en ce que** la teneur du composé (B) de bismaléimide est de 4 à 45 parties en poids par rapport à 100 parties en poids du composé (A) de bis-allyl-nadi-imide.

5. Composition de résine durcissable pour une imprimante à jet d'encre selon la revendication 1, dans laquelle la teneur du diluant (C) est de 25 à 1900 parties en poids par rapport à 100 parties en poids du composé (A) de bis-allyl-nadi-imide, à condition que dans le cas où le diluant (C) est un monomère polymérisable (C-2) seul, la teneur du diluant (C) soit de 25 à 200 parties en poids.

6. Produit durci obtenu par l'application de la composition de résine durcissable pour une imprimante à jet d'encre selon l'une quelconque des revendications 1 à 5 au moyen d'une imprimante à jet d'encre et du durcissement de la composition par voie thermique.

7. Produit durci obtenu par l'application de la composition de résine durcissable pour une imprimante à jet d'encre selon la revendication 1 au moyen d'une imprimante à jet d'encre, du photodurcissement de la composition au moyen d'un rayonnement ultraviolet, puis du durcissement de la composition par voie thermique.

8. Panneau de circuit imprimé ayant un motif de réserve de soudure obtenu par l'application de la composition de résine durcissable pour une imprimante à jet d'encre selon l'une quelconque des revendications 1 à 5 au moyen d'une imprimante à jet d'encre et du durcissement de la composition par voie thermique.

9. Panneau de circuit imprimé ayant un motif de réserve de soudure obtenu par l'application de la composition de résine durcissable pour une imprimante à jet d'encre selon la revendication 1 au moyen d'une imprimante à jet d'encre, du photodurcissement de la composition au moyen d'un rayonnement ultraviolet, puis du durcissement de la composition par voie thermique.
